# EUROPEAN PATENT APPLICATION

(11) **EP 4 742 482 A1**
(43) Date of publication of application: **13.05.2026**
(21) Application number: 25208866.1
(22) Date of filing: 15.10.2025
(51) Int. Cl.: H02J 3/32, H02J 3/00, H02J 7/65, H01M 10/48, G01R 31/382

(54) **TEMPERATURE PREDICTION METHOD, APPARATUS, ELECTRONIC DEVICE, AND ENERGY STORAGE SYSTEM**

(30) Priority: 06.11.2024 CN 202411577576; 06.11.2024 CN 202411580066
(71) Applicant: Zhejiang Jinko Energy Storage Co., Ltd., Jiaxing, Zhejiang (CN)
(72) Inventor: JIANG, Junjie, Haining City (CN); CAO, Baojian, Haining City (CN)
(74) Representative: Müller Schupfner & Partner Patent- und Rechtsanwaltspartnerschaft mbB (Muc)

(57) **Abstract**

The present disclosure provides a temperature prediction method and apparatus, an electronic device, a storage medium, and an energy storage system. The method includes: obtaining an ambient temperature and battery parameters of the energy storage device; obtaining a current first power, a third power, and a fourth power of the energy storage device; when a difference between the second power and the current first power is not less than the fourth power, determining a state of the energy storage device; outputting the predicted first power according to the state of the energy storage device; predicting the battery temperature of the energy storage device based on the ambient temperature, the battery parameters, and the predicted first power.

## Description

### TECHNICAL FIELD

The present disclosure relates to the field of energy storage technologies, and in particular, to a temperature prediction method and apparatus, an electronic device, a storage medium, and an energy storage system.

### BACKGROUND

In an energy storage system, it is necessary to ensure that the cells of the energy storage batteries in the energy storage cabinet and the associated electrical equipment operate within a safe temperature range.

In the related art, the temperature change of cells is predicted based on the changes in various data of the energy storage cabinet, and the battery is charged and discharged according to a planned long-term stable curve. However, under the anti-reverse current and anti-over-demand strategies in specific scenarios, the accurate temperature may not be easily predicted.

### SUMMARY

In view of the above, the present disclosure provides a temperature prediction method and apparatus, an electronic device, a storage medium, and an energy storage system, which helps to solve the problem that the battery temperature change of the energy storage device may not be accurately predicted under the anti-reverse current and anti-over-demand strategies.

In a first aspect, the present disclosure provides a temperature prediction method applied to an energy storage device, including: obtaining an ambient temperature and battery parameters of the energy storage device; obtaining a current first power, a third power, and a fourth power of the energy storage device, the current first power is configured to indicate a current operating power of the energy storage device, the third power is configured to indicate an anti-reverse current threshold power of the energy storage device, and the fourth power is configured to indicate an anti-over-demand threshold power of the energy storage device; calculating a second power of the energy storage device, the second power is configured to indicate a load power of the energy storage device; determining a state of the energy storage device in response to a difference between the second power and the current first power being not less than the fourth power. When the energy storage device is in a charging state, the method further includes: compensating a predicted first power based on the current first power, the predicted first power is configured to indicate a predicted operating power of the energy storage device; determining whether a difference between the second power and the compensated predicted first power is less than the fourth power; outputting the predicted first power in response to the difference between the second power and the compensated predicted first power being less than the fourth power; adding a preset first adjustment value to the predicted first power until the difference between the second power and the current first power is less than the fourth power in response to the difference between the second power and the predicted first power being not less than the fourth power, and outputting the adjusted predicted first power. When the energy storage device is in a discharging state, the method further includes: compensating the predicted first power based on the current first power; determining whether the difference between the second power and the predicted first power is less than the fourth power; outputting the predicted first power in response to the difference between the second power and the predicted first power being less than the fourth power; adding the preset first adjustment value to the predicted first power until the difference between the second power and the current first power is less than the fourth power in response to the difference between the second power and the predicted first power being not less than the fourth power, and output the adjusted predicted first power. When the energy storage device is in a static fully-charged state, the method further includes: set the predicted first power to zero; determining whether the difference between the second power and the predicted first power is less than the fourth power; output the predicted first power in response to the difference between the second power and the predicted first power is less than the fourth power; adding the preset first adjustment value to the predicted first power until the difference between the second power and the current first power is less than the fourth power in response to the difference between the second power and the predicted first power is not less than the fourth power, and outputting the adjusted predicted first power. The method further includes: predicting battery temperature of the energy storage device based on the ambient temperature, the battery parameters, and the predicted first power.

In one or more embodiments, the battery parameters include a parameter of state of charge (SOC) and a parameter of state of health (SOH).

In one or more embodiments, the calculating a second power of the energy storage device includes: calculating the second power of the energy storage device based on historical power data, date data, weather condition, and air quality of the energy storage device.

In one or more embodiments, the calculating the second power of the energy storage device based on historical power data, date data, weather condition, and air quality of the energy storage device includes: inputting the historical power data, date data, weather conditions, and air quality of the energy storage device into a preset model, to output power load demand of the energy storage device, and calculate the second power of the energy storage device.

In one or more embodiments, the method further includes: adjusting the predicted first power based on the current first power and a preset second adjustment value in response to the difference between the second power and the current first power being not greater than the third power.

In one or more embodiments, the determining a state of the energy storage device and adjusting the first power includes: when the energy storage device is in the charging state, increasing the predicted first power until the charging state stops; when the energy storage device is in the discharging state, increasing the predicted first power for discharging; and when the energy storage device is in the static fully-charged state, increasing the predicted first power for discharging.

In one or more embodiments, the adjusting the predicted first power based on the current first power and a preset second adjustment value includes: in response to the difference between the second power and the current first power being not greater than the third power, compensating the predicted first power based on the current first power; determining whether the difference between the second power and the predicted first power is greater than the third power; in response to the difference between the second power and the predicted first power being greater than the third power, outputting the predicted first power; and in response to the difference between the second power and the predicted first power being not greater than the third power, subtracting the preset second adjustment value from the predicted first power until the difference between the second power and the current first power is greater than the third power, and outputting the adjusted predicted first power.

In one or more embodiments, the energy storage device further includes a liquid cooler, and the predicting battery temperature of the energy storage device based on the ambient temperature, the battery parameters, and the predicted first power includes: training a temperature prediction model based on the second power, the ambient temperature, the battery parameters, and power of the liquid cooler; and inputting the ambient temperature, the battery parameters, and the predicted first power into the temperature prediction model to predict the battery temperature of the energy storage device.

In one or more embodiments, the battery temperature of the energy storage device includes a maximum cell temperature T1 and a minimum cell temperature T2, and the method further includes: obtaining a first liquid-cooling mode, the first liquid-cooling mode is a current liquid-cooling mode of the energy storage device; and determining a second liquid-cooling mode based on the first liquid-cooling mode, the maximum cell temperature T1, and/or the minimum cell temperature T2, the second liquid-cooling mode is a liquid-cooling mode of the energy storage device after a first duration.

In one or more embodiments, liquid-cooling modes of the energy storage device include a shutdown mode, a first-level cooling mode, a second-level cooling mode, a third-level cooling mode, a self-circulation mode, and a heating mode, and target water temperatures of the heating mode, the first-level cooling mode, the second-level cooling mode, and the third-level cooling mode decrease in sequence.

In one or more embodiments, the determining a second liquid-cooling mode based on the first liquid-cooling mode, the maximum cell temperature T1, and/or the minimum cell temperature T2 includes: in the case where the first liquid-cooling mode is the shutdown mode, determining the second liquid-cooling mode, including: when T1 ≥ 38°C and T2 ≥ 12°C, determining that the second liquid-cooling mode is the third-level cooling mode; when the energy storage device is in the discharging state or a standby state, with 35°C ≤ T1 < 38°C and T2 ≥ 12°C, or when the energy storage device is in the charging state, with 33°C ≤ T1 < 38°C and T2 ≥ 12°C, determining that the second liquid-cooling mode is the second-level cooling mode; when 27°C ≤ T1 < 33°C and T2 ≥ 12°C, determining that the second liquid-cooling mode is the first-level cooling mode; when T1 - T2 ≥ 5°C, determining that the second liquid-cooling mode is the self-circulation mode; and when T1 < 27°C and T2 ≤ 12°C, determining that the second liquid-cooling mode is the heating mode.

In one or more embodiments, the determining a second liquid-cooling mode based on the first liquid-cooling mode, the maximum cell temperature T1, and/or the minimum cell temperature T2 includes: in the case where the first liquid-cooling mode is the third-level cooling mode, when T1 ≤ 36°C, determining that the second liquid-cooling mode is the second-level cooling mode.

In one or more embodiments, the determining a second liquid-cooling mode based on the first liquid-cooling mode, the maximum cell temperature T1, and/or the minimum cell temperature T2 includes: in the case where the first liquid-cooling mode is the second-level cooling mode, determining the second liquid-cooling mode, including: when T1 ≥ 38°C, determining that the second liquid-cooling mode is the third-level cooling mode; or when the energy storage device is in the discharging state or a standby state, with T1 ≤ 33°C, or when the energy storage device is in the charging state, with T1 ≤ 31°C, determining that the second liquid-cooling mode is the first-level cooling mode.

In one or more embodiments, the determining a second liquid-cooling mode based on the first liquid-cooling mode, the maximum cell temperature T1, and/or the minimum cell temperature T2 includes: in the case where the first liquid-cooling mode is the first-level cooling mode, determining the second liquid-cooling mode, including: when the energy storage device is in the discharging state or a standby state, with T1 ≥ 35°C, or when the energy storage device is in the charging state, with T1 ≥ 33°C, determining that the second liquid-cooling mode is the second-level cooling mode; or when T1 ≤ 25°C or T2 ≤ 9°C, determining that the second liquid-cooling mode is the self-circulation mode.

In one or more embodiments, the determining a second liquid-cooling mode based on the first liquid-cooling mode, the maximum cell temperature T1, and/or the minimum cell temperature T2 includes: in the case where the first liquid-cooling mode is the self-circulation mode, determining the second liquid-cooling mode, including: when T1 ≥ 27°C and T2 ≤ 9°C, determining that the second liquid-cooling mode is the first-level cooling mode; when T1 < 27°C and T2 ≤ 12°C, determining that the second liquid-cooling mode is the heating mode.; or when T1 - T2 ≤ 5°C, determining that the second liquid-cooling mode is the shutdown mode.

In one or more embodiments, the determining a second liquid-cooling mode based on the first liquid-cooling mode, the maximum cell temperature T1, and/or the minimum cell temperature T2 includes: in the case where the first liquid-cooling mode is the heating mode, when T1 ≥ 30°C or T2 ≤ 15°C, determining that the second liquid-cooling mode is the self-circulation mode.

In one or more embodiments, the method further includes: in response to the second power being greater than the third power and less than the fourth power, determining that the predicted first power is the second power.

In a second aspect, the present disclosure provides a temperature prediction apparatus, applied to an energy storage device, which includes an acquisition module configured to obtain an ambient temperature and battery parameters of the energy storage device, and further configured to obtain a current first power, a third power, and a fourth power of the energy storage device, the current first power configured to indicate a current operating power of the energy storage device, the third power configured to indicate an anti-reverse current threshold power of the energy storage device, and the fourth power configured to indicate an the anti-over-demand threshold power of the energy storage device. The apparatus further includes a calculation module configured to calculate a second power of the energy storage device and determine a state of the energy storage device in response to a the difference between the second power and the current first power being not less than the fourth power, the second power configured to indicate a load power of the energy storage device. The apparatus further includes a compensation module configured to: compensate a predicted first power based on the current first power when the energy storage device is in the charging state, the predicted first power configured to indicate a predicted operating power of the energy storage device; determine whether a difference between the second power and the compensated predicted first power is less than the fourth power; in response to the difference between the second power and the compensated predicted first power being less than the fourth power, output the predicted first power; and in response to the difference between the second power and the predicted first power is not less than the fourth power, add a preset first adjustment value to the predicted first power until the difference between the second power and the current first power is less than the fourth power, and output the adjusted predicted first power. The compensation module is further configured to: compensate the predicted first power based on the current first power when the energy storage device is in the discharging state; determine whether the difference between the second power and the predicted first power is less than the fourth power; in response to the difference between the second power and the predicted first power being less than the fourth power, output the predicted first power; in response to the difference between the second power and the predicted first power being not less than the fourth power, add the preset first adjustment value to the predicted first power until the difference between the second power and the current first power is less than the fourth power, and output the adjusted predicted first power. The compensation module is further configured to: set the predicted first power to zero when the energy storage device is in a static fully-charged state; determine whether the difference between the second power and the predicted first power is less than the fourth power; in response to the difference between the second power and the predicted first power being less than the fourth power, output the predicted first power; and in response to the difference between the second power and the predicted first power being not less than the fourth power, add the preset first adjustment value to the predicted first power until the difference between the second power and the current first power is less than the fourth power, and output the adjusted predicted first power. The temperature prediction apparatus further includes: a prediction module configured to predict battery temperature of the energy storage device based on the ambient temperature, the battery parameters, and the predicted first power.

In one or more embodiments, the battery parameters include a parameter of SOC parameter and a parameter of SOH.

In one or more embodiments, the calculation module is configured to calculate the second power of the energy storage device based on historical power data, date data, weather condition, and air quality of the energy storage device.

In one or more embodiments, the calculation module is configured to input the historical power data, date data, weather condition, and air quality of the energy storage device into a preset model, to output power load demand of the energy storage device, and calculate the second power of the energy storage device.

In one or more embodiments, the temperature prediction device further includes an adjustment module, configured to adjust the predicted first power based on the current first power and a preset second adjustment value in response to the difference between the second power and the current first power being not greater than the third power.

In one or more embodiments, the adjustment module is configured to: increase the predicted first power until the charging state stops when the energy storage device is in the charging state; increase the predicted first power for discharging when the energy storage device is in the discharging state; and increase the predicted first power for discharging when the energy storage device is in the static fully-charged state.

In one or more embodiments, the compensation module is configured to: in response to the difference between the second power and the current first power being not greater than the third power, compensate the predicted first power based on the current first power; determine whether the difference between the second power and the predicted first power is greater than the third power; in response to the difference between the second power and the predicted first power being greater than the third power, output the predicted first power; and in response to the difference between the second power and the predicted first power being not greater than the third power, subtract the preset second adjustment value from the predicted first power until the difference between the second power and the current first power is greater than the third power, and output the adjusted predicted first power.

In one or more embodiments, the prediction module is further configured to: train a temperature prediction model based on the second power, the ambient temperature, the battery parameters, and power of a liquid cooler; and input the ambient temperature, the battery parameters, and the predicted first power into the temperature prediction model to predict the battery temperature of the energy storage device.

In one or more embodiments, the battery temperature of the energy storage device includes a maximum cell temperature T1 and a minimum cell temperature T2, and the acquisition module is configured to obtain a first liquid-cooling mode, which is a current liquid-cooling mode of the energy storage device. The apparatus further includes a determination module configured to determine a second liquid-cooling mode based on the first liquid-cooling mode, the maximum cell temperature T1, and/or the minimum cell temperature T2. The second liquid-cooling mode is a liquid-cooling mode of the energy storage device after a first duration.

In one or more embodiments, liquid-cooling modes of the energy storage device include a shutdown mode, a first-level cooling mode, a second-level cooling mode, a third-level cooling mode, a self-circulation mode, and a heating mode. Target water temperatures of the heating mode, the first-level cooling mode, the second-level cooling mode, and the third-level cooling mode decrease in sequence.

In one or more embodiments, in the case where the first liquid-cooling mode is the shutdown mode, the determination module is configured to: determine the second liquid-cooling mode, including: when T1 ≥ 38°C and T2 ≥ 12°C, determine that the second liquid-cooling mode is the third-level cooling mode; when the energy storage device is in the discharging state or a standby state, with 35°C ≤ T1 < 38°C and T2 ≥ 12°C, or when the energy storage device is in the charging state, with 33°C ≤ T1 < 38°C and T2 ≥ 12°C, determine that the second liquid-cooling mode is the second-level cooling mode; when 27°C ≤ T1 < 33°C and T2 ≥ 12°C, determine that the second liquid-cooling mode is the first-level cooling mode; when T1 - T2 ≥ 5°C, determine that the second liquid-cooling mode is the self-circulation mode; or when T1 < 27°C and T2 ≤ 12°C, determine that the second liquid-cooling mode is the heating mode.

In one or more embodiments, in the case where the first liquid-cooling mode is the third-level cooling mode, the determination module is configured to: when T1 ≤ 36°C, determining that the second liquid-cooling mode is the second-level cooling mode.

In one or more embodiments, in the case where the first liquid-cooling mode is the second-level cooling mode, the determination module is configured to: when T1 ≥ 38°C, determining that the second liquid-cooling mode is the third-level cooling mode; or when the energy storage device is in the discharging state or a standby state, with T1 ≤ 33°C, or when the energy storage device is in the charging state, with T1 ≤ 31°C, determining that the second liquid-cooling mode is the first-level cooling mode.

In one or more embodiments, in the case where the first liquid-cooling mode is the first-level cooling mode, the determination module is configured to: when the energy storage device is in the discharging state or a standby state, with T1 ≥ 35°C, or when the energy storage device is in the charging state, with T1 ≥ 33°C, determining that the second liquid-cooling mode is the second-level cooling mode; or when T1 ≤ 25°C or T2 ≤ 9°C, determining that the second liquid-cooling mode is the self-circulation mode.

In one or more embodiments, in the case where the first liquid-cooling mode is the self-circulation mode, the determination module is configured to: when T1 ≥ 27°C and T2 ≤ 9°C, determining that the second liquid-cooling mode is the first-level cooling mode; when T1 < 27°C and T2 ≤ 12°C, determining that the second liquid-cooling mode is the heating mode; or when T1 - T2 ≤ 5°C, determining that the second liquid-cooling mode is the shutdown mode.

In one or more embodiments, in the case where the first liquid-cooling mode is the heating mode, the determination module is configured to: when T1 ≥ 30°C or T2 ≤ 15°C, determining that the second liquid-cooling mode is the self-circulation mode.

In one or more embodiments, the determination module is further configured to: in response to the second power being greater than the third power and less than the fourth power, determining that the predicted first power is the second power.

In a third aspect, the present disclosure provides an electronic device, which includes at least one processor and a memory. The memory is configured to store a computer program, and the at least one processor is configured to run the computer program to implement the temperature prediction method described in the first aspect.

In a fourth aspect, the present disclosure provides a computer-readable storage medium, which stores a computer program. When the computer program is run on a computer, the computer program enables the computer to implement the temperature prediction method described in the first aspect.

### BRIEF DESCRIPTION OF DRAWINGS

Fig. 1 is a schematic flowchart of an operation strategy of an energy storage device according to one or more embodiments of the present disclosure;
Fig. 2 is a schematic flowchart of a temperature prediction method according to one or more embodiments of the present disclosure;
Fig. 3 is a schematic diagram of a basic structure of a convolutional neural network model according to one or more embodiments of the present disclosure;
Fig. 4 is a schematic diagram of a basic structure of a long-short-term memory network model according to one or more embodiments of the present disclosure;
Fig. 5 is a schematic flowchart of a training method for a power load calculation model according to one or more embodiments of the present disclosure;
Fig. 6 is a schematic flowchart of a power prediction method according to one or more embodiments of the present disclosure;
Fig. 7 is a schematic flowchart of a liquid-cooling control strategy in the related art;
Fig. 8 is a structural schematic diagram showing liquid-cooling mode conversion according to one or more embodiments of the present disclosure;
Fig. 9 is a structural schematic diagram of a temperature prediction apparatus according to one or more embodiments of the present disclosure; and
Fig. 10 is a structural schematic diagram of an electronic device according to one or more embodiments of the present disclosure.

### DESCRIPTION OF EMBODIMENTS

In embodiments of the present disclosure, unless otherwise specified, the character "/" indicates an "or" relationship between the associated objects. For example, A/B can indicate A or B. "And/or" describes the association relationship of associated objects, indicating that there can be three relationships. For example, A and/or B can include three situations: A exists alone, A and B exist simultaneously, and B exists alone.

It should be noted that words such as "first" and "second" involved in embodiments of the present disclosure are only used for the distinguishing purpose, and shall not be understood as indicating or implying relative importance, nor as implicitly indicating the quantity of the indicated technical features, nor as indicating or implying the order.

In embodiments of the present disclosure, "at least one" means one or more, and "multiple" means two or more. In addition, "at least one of the followings" or similar expressions refer to any combination of these items, which can include any combination of singular item or plural items. For example, at least one of A, B, or C can indicate: A, B, C, A and B, A and C, B and C, or A, B, and C. Here, each of A, B, and C can be an element or a set containing one or more elements.

In embodiments of the present disclosure, terms such as "exemplary," "in some embodiments," and "in some other embodiments" are used to represent examples, illustrations, or explanations. Any embodiment or design solution described as "exemplary" in the present disclosure should not be construed as more preferable or more advantageous than other embodiments or design solutions. Rather, the term "exemplary" is used to present concepts in a specific manner.

In embodiments of the present disclosure, terms "of", "relevant", and "corresponding" can sometimes be used interchangeably. It should be noted that when their differences are not emphasized, the meanings they express are similar. In embodiments of the present disclosure, "communication" and "transmission" can sometimes be used interchangeably. It should be noted that when their differences are not emphasized, the meanings they express are similar. For example, "transmission" can include sending and/or receiving, and can be either a noun or a verb.

In embodiments of the present disclosure, "equal to" can be used in conjunction with "greater than", applying to the technical solutions adopted when it is greater than, or can be used in conjunction with "less than", applying to the technical solutions adopted when it is less than. It should be noted that when "equal to" is used in conjunction with "greater than", it cannot be used in conjunction with "less than"; when "equal to" is used in conjunction with "less than", it cannot be used in conjunction with "greater than".

In the related art, the temperature prediction model has difficulty in predicting the temperature change within ten minutes after the anti-reverse current and anti-over-demand strategies are triggered and stopped. Only after the anti-reverse current and anti-over-demand strategies have been running for a certain period and stopped for a certain period, and the power has changed, the subsequent temperature change can be predicted based on the current power.

Based on the above problems, some embodiments of the present disclosure provide a temperature prediction method applied to an energy storage device.

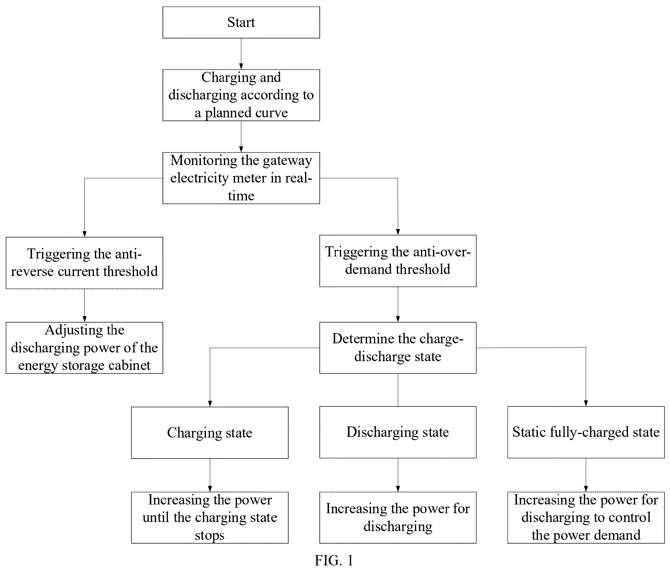

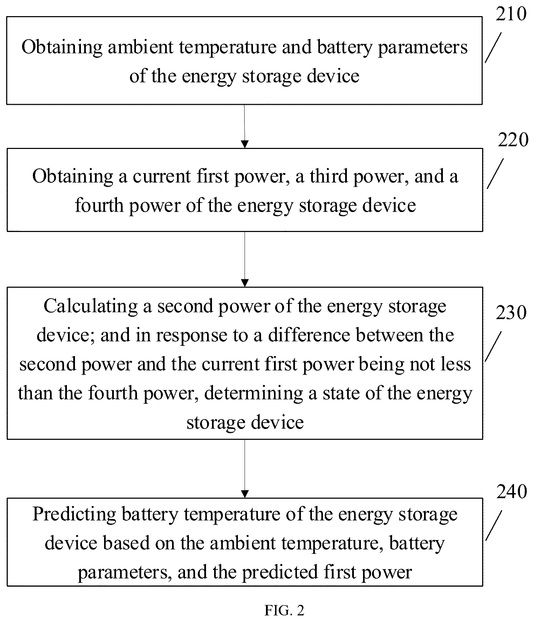

The temperature prediction method provided will be described with reference to Fig. 1 and Fig. 2.

Fig. 1 is a schematic flowchart of an operation strategy of an energy storage device according to one or more embodiments of the present disclosure. As shown in Fig. 1, the above-mentioned operation strategy includes operation strategies of the energy storage device in the industrial and commercial scenarios. First, charging and discharging are carried out according to the charge-discharge time set in the planned curve. Generally, charging is carried out during the off-peak electricity price period, and discharging is carried out during the peak electricity price period. Then, the gateway electricity meter is monitored in real-time, and it is determined whether the power of the gateway electricity meter triggers the anti-reverse current threshold and the anti-over-demand threshold. The gateway electricity meter usually refers to the electricity meter installed at the connection point between the industrial and commercial energy storage system/load/other systems and the power grid. The function of this electricity meter is to measure and record the exchange of electrical energy between the energy storage system/load/other systems and the power grid. For example, it can measure and record the electricity output when the energy storage system discharges to the power grid and the electricity input when charging from the power grid.

When the gateway electricity meter monitors the anti-reverse current threshold power, the anti-reverse current strategy is executed, and the energy storage device operates at a decreased power. When the gateway electricity meter monitors the anti-over-demand threshold power, the anti-over-demand strategy is executed, and the power of the energy storage device is adjusted according to the current charging state of the energy storage device. When the energy storage device is in the charging state, the power is increased until the charging state stops. When the energy storage device is in the discharging state, the power is increased for discharging. When the energy storage device is in the static fully-charged state, the power is increased for discharging to control the power demand.

Fig. 2 is a schematic flowchart of a temperature prediction method according to one or more embodiments of the present disclosure, which includes the following steps:

Step 210: Obtaining ambient temperature and battery parameters of the energy storage device.

In some embodiments of the present disclosure, the ambient temperature where the energy storage device is located and the battery parameters of the energy storage device are obtained first. The energy storage device can include multiple temperature sensors, which can be installed inside or outside the energy storage device, and the energy storage device obtains the ambient temperature through the temperature sensors. The acquisition manner is not limited by embodiments of the present disclosure. The battery parameters of the energy storage device can include: a parameter of State of Charge (SOC), a parameter of State of Health (SOH), battery capacity, rated voltage, charge-discharge rate, charge-discharge depth, maximum charge-discharge power, and battery rated voltage, etc. The SOC is the percentage of the remaining battery power to the rated battery capacity, which is used to reflect the remaining battery capacity. The range of SOC is generally from 0 to 100%. The SOH is the ratio of the performance parameters to the nominal parameters after the battery has been used for a period of time. According to the IEEE standard, when the capacity of the fully-charged battery is less than 80% of the rated capacity, that is, when SOH is less than 80%, the battery should be replaced. The battery capacity is one of the important performance indicators for evaluating the battery performance, which represents the amount of discharge electricity of the battery under certain conditions. The rated voltage of the battery in the energy storage device refers to its designed or nominal operating voltage, expressed in volts (V). The batteries in the energy storage device are formed by connecting single cells in parallel and series. Series connection increases the voltage, and parallel connection increases the capacity. The battery charge-discharge rate is a measure of the charging speed, which affects the continuous current and peak current during battery operation. The charge-discharge depth is used to measure the percentage of the battery discharge amount to the rated battery capacity. The deeper the discharge depth, the shorter the battery cycle life. The maximum charge-discharge power is the maximum current and power during battery charging and discharging. The rated voltage of the battery will change under different discharge currents and ambient temperatures. The larger the discharge current, the lower the voltage, and the lower the temperature, the lower the voltage of the battery with the same capacity.

Step 220: Obtaining a current first power, a third power, and a fourth power of the energy storage device.

In some embodiments of the present disclosure, the current first power, the third power, and the fourth power of the energy storage device are obtained. The current first power is used to indicate the current operating power of the energy storage device, the third power is used to indicate the anti-reverse current threshold power of the energy storage device, and the fourth power is used to indicate the anti-over-demand threshold power of the energy storage device. The anti-reverse current threshold power is a key parameter in the energy storage system, which defines the maximum amount of electrical energy that the energy storage system can provide to the power grid or the load during the discharge process. During the discharge process of the energy storage system, power fluctuations, changes in load power consumption, and other factors can cause the electrical energy to reverse its current direction back to the power grid, which may affect the stability and safety of the power grid. Reverse current may also cause damage to the energy storage device, and improper charging and discharging processes may shorten the battery life. By setting the anti-reverse current threshold power, it helps to protect the energy storage device, prolong its service life, and further ensure that the energy storage system does not input excessive energy into the power grid, thereby maintaining the stability of the power grid. The anti-over-demand threshold power refers to preventing the power provided by the energy storage system during the discharge process within a specific time period from exceeding the actual demand of the power grid or the load. This time period can be 15 minutes, one hour, one day, etc., depending on the management and measurement requirements of the power system. Through this time period, the power grid demand is usually the average maximum value of the actual power consumed by the user. When the gateway electricity meter calculates that the over-demand threshold is reached, it will adjust the strategy of the energy storage device according to the current state of the energy storage device. The dynamic adjustment of the anti-reverse current strategy and the anti-over-demand strategy provided by some embodiments of the present disclosure is mainly based on whether the anti-reverse current threshold power and the anti-over-demand threshold power are triggered. Based on the current first power, the third power, and the fourth power, the load power can be effectively predicted, and the power change of the energy storage device can be effectively predicted. Based on the charge-discharge power of the energy storage cabinet, the temperature change of the cells in the energy storage device can be effectively predicted.

Step 230: Calculating a second power of the energy storage device; and in response to a difference between the second power and the current first power being not less than the fourth power, determining a state of the energy storage device.

In some embodiments of the present disclosure, the second power of the energy storage device is calculated. When the difference between the second power and the current first power is not less than the fourth power, the state of the energy storage device is determined. The second power is used to indicate the load power of the energy storage device. The calculating the second power of the energy storage device includes calculating the second power of the energy storage device based on historical power data, date data, weather conditions, and air quality of the energy storage device.

Further, the historical power data, date data, weather conditions, and air quality of the energy storage device are put into the power load calculation model, so as to output the power load demand of the energy storage device, and then calculate the second power. The historical power data refers to the power load data over a past period of time, which can be the power load data in the previous week, previous month, or previous three months, etc. The date data refers to different date types (such as weekdays, weekends, holidays). Different date types will lead to significant changes in the power load. For example, holidays usually have lower industrial and commercial loads, while residential loads may increase because people are at home. The weather conditions refer to weather factors (such as temperature, humidity, wind speed, precipitation). Weather conditions may have a direct impact on the power load. For example, hot weather may increase the use of air-conditioners, thereby increasing the power demand, while cold weather may increase the use of heating systems. In addition to the above factors, other factors that affect the power load, such as seasonal temperature changes and charge-discharge plans, can also be input into the power load calculation model.

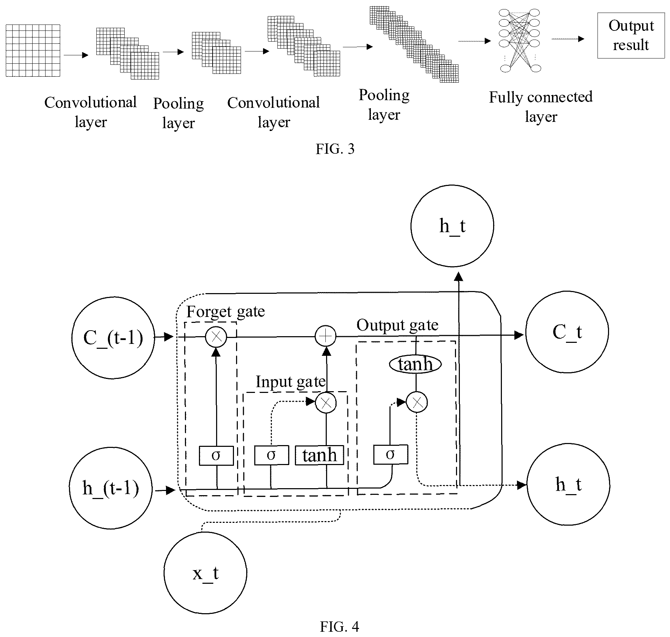

The power load calculation model in the present disclosure can include: the Long-Short-Term Memory (LSTM) model or the Convolutional Neural Networks-LSTM (CNN-LSTM) model. Fig. 3 is a schematic diagram of a basic structure of a convolutional neural network model according to one or more embodiments of the present disclosure, and Fig. 4 is a schematic diagram of a basic structure of a long-short-term memory network model according to one or more embodiments of the present disclosure. As shown in Fig. 3, a convolutional neural network usually includes an input layer, multiple convolutional layers, pooling layers, fully-connected layers, etc. The convolutional layers automatically extract local features of the image, and can capture local spatial structure information of the image. The convolutional layers and pooling layers of the CNN are used to extract effective features from the input data, thereby fully exploring their internal relationships, and thus reducing noise. As shown in Fig. 4, the long-short-term memory network model unit contains three gates, that is, an input gate, a forget gate, and an output gate, as well as a cell state, and a hidden state. These gates control the flow of information. The forget gate determines which old information is to be forgotten, the input gate controls the acceptance degree of new information, and the output gate determines how much information in the cell state will be used to generate the hidden state. In Fig. 4, h_t represents the hidden state at the current time step, h_(t-1) represents the hidden state at the previous time step, C_t represents the cell state at the current time step, C_(t-1) represents the cell state at the previous time step, x_t represents the input at the current time step, σ is the sigmoid activation function, and tanh is the activation function. The long-short-term memory network model is mainly used for tasks of processing and predicting time-series data, such as language modeling, text generation, speech recognition, etc.

In some embodiments of the present disclosure, the convolutional neural network and long-short-term memory network can be combined. First, the convolutional neural network is used to extract features from the input object, and the features of each frame are extracted. Optionally, the spatial dimension of the features is further reduced to extract more abstract features. Then, the LSTM layer takes the feature sequence extracted by the CNN as input, the LSTM is used to process the time-series relationship of these features, and capture the dynamic changes over time, thereby predicting the power load. Finally, the fully-connected layer is used for classification or regression tasks and to evaluate the prediction results.

In some embodiments of the present disclosure, by combining the CNN and LSTM models for power load prediction, the convolutional and pooling layers of the CNN model can be used to extract effective features from the input data, thereby fully exploring their internal relationships, improving the prediction accuracy, and strengthening the data coupling. In addition, the LSTM model can be used to process time-series data. The CNN-LSTM model makes full use of the input load data and influencing factors, combines the advantages of CNN and LSTM, and thus improving the prediction effect.

In some embodiments, the power load calculation model can be trained in the cloud, and the trained model can be sent to the local energy storage device to perform load prediction locally. Using the cloud-edge collaboration method can fully utilize the advantages of the cloud in processing large amounts of data, high processing speed, large storage capacity, and powerful computing, which helps to accelerate model training.

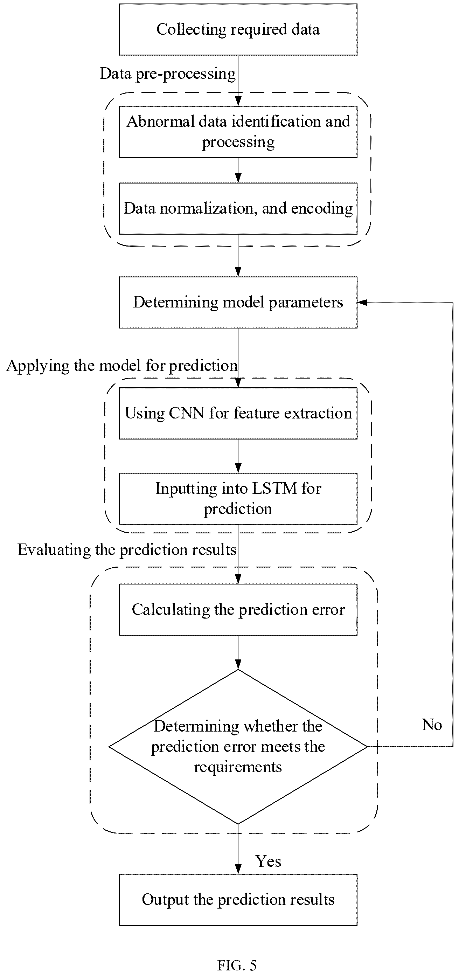

Fig. 5 is a schematic flowchart of a training method for a power load calculation model according to one or more embodiments of the present disclosure, which includes collecting required data, data pre-processing (including abnormal data identification and processing, data normalization, and encoding), determining model parameters, applying the model for prediction (including using CNN for feature extraction and inputting into LSTM for prediction), evaluating the prediction results (including calculating the prediction error and determining whether the prediction error meets the requirements). If the requirements are met, the prediction results are output; if not, the model parameters need to be modified and re-determined.

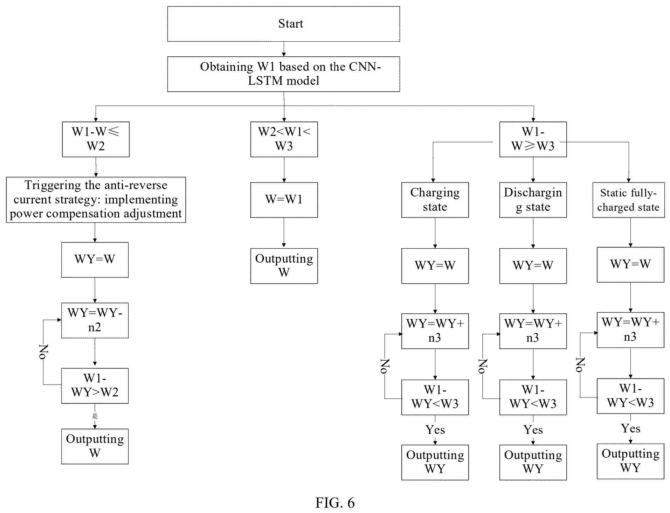

Fig. 6 is a schematic flowchart of a power prediction method according to one or more embodiments of the present disclosure. As shown in Fig. 6, W represents the current first power, WY represents the predicted first power predicted based on the above-mentioned convolutional neural network and long-short-term memory network model, W1 represents the second power, W2 represents the third power, W3 represents the fourth power, n3 represents the preset first adjustment value, and n2 represents the preset second adjustment value.

The preset first adjustment value n3 means that in the energy storage system, in order to achieve the anti-over-demand function, the power control system of the energy storage system will adjust the operating power with a fixed-size power change. This fixed size is the step size, which is the minimum unit of power change, i.e., step size n3.

The preset second adjustment value n2 means that in the energy storage system, in order to achieve the anti-reverse current function, the power control system of the energy storage system will adjust the operating power with a fixed-size power change. This fixed size is the step size, which is the minimum unit of power change, i.e., step size n2. For example, if n2 is set to 10 kW, then each time the system makes an adjustment, the output power of the inverter will increase or decrease by 10 kW. When the Battery Management System (BMS) detects an reverse current phenomenon, it will adjust the operating power of the energy storage cabinet step-by-step in units of the step size by adjusting the output power of the inverter until the reverse current phenomenon is eliminated.

In actual operation, in order to ensure the stability of the power grid and avoid unnecessary burdens on the power grid, the energy storage system needs to precisely control its charge-discharge power. By setting appropriate adjustment step sizes (n2 and n3), the system can control the power change more precisely, thereby more effectively managing electrical energy and preventing reverse current. Optionally, n2 = 10 kW and n3 = 10 kW.

In some embodiments, the energy storage system can also make a one-time adjustment directly. For example, the power is directly adjusted from 180 kW to 100 kW in one step.

In some embodiments, a power hysteresis value can also be set. When there is a certain fluctuation in power/load, the system will not immediately make an adjustment. Instead, it will take action only after the fluctuation exceeds a preset threshold (i.e., the hysteresis value). This can avoid frequently triggering the adjustment mechanism due to minor fluctuations, thereby reducing algorithm oscillations and unnecessary adjustments, and improving the overall stability and response efficiency of the system.

In some embodiments, when the difference between the second power and the current first power is not less than the fourth power, that is, the anti-over-demand threshold power is triggered, and the anti-over-demand strategy is executed. First, the state of the energy storage device is determined. When the energy storage device is in the charging state, the predicted first power is compensated based on the current first power. The predicted first power is used to indicate the predicted operating power of the energy storage device. Then, it is determined whether the difference between the second power and the compensated predicted first power is less than the fourth power. When the difference is less than the fourth power, the predicted first power is output. When the difference is not less than the fourth power, the preset first adjustment value is added to the predicted first power until the difference between the second power and the current first power is less than the fourth power, and the adjusted predicted first power is output.

In some embodiments, when the energy storage device is in the discharging state, the predicted first power is compensated based on the current first power. It is determined whether the difference between the second power and the predicted first power is less than the fourth power. When the difference is less than the fourth power, the predicted first power is output. When the difference is not less than the fourth power, the preset first adjustment value is added to the predicted first power until the difference between the second power and the current first power is less than the fourth power, and the adjusted predicted first power is output.

In some embodiments, when the energy storage device is in the static fully-charged state, the predicted first power is set to zero. It is determined whether the difference between the second power and the predicted first power is less than the fourth power. When the difference is less than the fourth power, the predicted first power is output. When the difference is not less than the fourth power, the preset first adjustment value is added to the predicted first power until the difference between the second power and the current first power is less than the fourth power, and the adjusted predicted first power is output. The preset first adjustment value can be different values in different application scenarios and can be set to vary with different anti-over-demand strategies. The present disclosure does not make special restrictions on the specific value of the preset first adjustment value.

In some other embodiments, when the difference between the second power and the current first power is not greater than the third power, the anti-reverse current threshold power is triggered, and the anti-reverse current strategy is executed. The predicted first power is adjusted based on the current first power and the preset second adjustment value. First, the working state of the energy storage device is determined. When the energy storage device is in the charging state, the predicted first power is increased until the charging state stops. When the energy storage device is in the discharging state, the predicted first power is increased for discharging. When the energy storage device is in the static fully-charged state, the predicted first power is increased for discharging. It can be understood that in the present disclosure, the predicted first power is adjusted according to the anti-reverse current strategy. For example, when the difference between the second power and the current first power is not greater than the third power, the predicted first power is compensated based on the current first power. It is determined whether the difference between the second power and the predicted first power is greater than the third power. When the difference is greater than the third power, the predicted first power is output. When the difference is not greater than the third power, the preset second adjustment value is subtracted from the predicted first power until the difference between the second power and the current first power is greater than the third power, and the adjusted predicted first power is output. The preset second adjustment value can be different values in different application scenarios and can be set to vary with different anti-reverse current strategies. The present disclosure does not make special restrictions on the specific value of the preset second adjustment value.

In some other embodiments, when the second power is greater than the third power and less than the fourth power, the predicted first power is the second power. That is, as shown in Fig. 6, when W2 < W1 < W3, W = W1.

In some embodiments, when the energy storage device is charging, it has a negative power value, and when discharging, it has a positive power value. For example, in some embodiments of the present disclosure, W2 can be 20 kW, W can be 100 kW, and WY can be 100 kW. W1 can be 100 kW, that is, W1 - W is 0, which triggers the reverse current, and the anti-reverse current strategy is executed. The preset second adjustment value is subtracted from WY, where the preset second adjustment value can be 5 kW, 10 kW, or any value not greater than W2, until W1 - WY > W2. When W1 is 200 kW and W is 100 kW, that is, W1 - W is 100 kW, which is greater than W2, the reverse current is not triggered, and the anti-reverse current strategy is not executed.

In some embodiments, when the energy storage device is in the charging state, W3 can be 300 kW, W can be -100 kW, and WY can be -100 kW. W1 can be 240 kW, that is, W1 - W is 340 kW, which is greater than W3, the over-demand is triggered, and the anti-over-demand strategy is executed. The preset first adjustment value is added to WY, where the preset first adjustment value can be 5 kW, 10 kW, until W1 - WY < W3. When W1 is 150 kW and W is 100 kW, that is, W1 - W is 100 kW, which is less than W3, the over-demand is not triggered, and the anti-over-demand strategy is not executed.

In some embodiments, when the energy storage device is in the discharging state, W3 can be 300 kW, W can be -100 kW, and WY can be -100 kW. W1 can be 240 kW, that is, W1 - W is 340 kW, which is greater than W3, the over-demand is triggered, and the anti-over-demand strategy is executed. The preset first adjustment value is added to WY, where the preset first adjustment value can be 5 kW, 10 kW, until W1 - WY < W3. When W1 is 150 kW and W is 100 kW, that is, W1 - W is 100 kW, which is less than W3, the over-demand is not triggered, and the anti-over-demand strategy is not executed.

In some embodiments, when the energy storage device is in the static fully-charged state, W3 can be 300 kW, W can be -100 kW, and WY can be 0. W1 can be 240 kW, that is, W1 - W is 340, which is greater than W3, the over-demand is triggered, and the anti-over-demand strategy is executed. The preset first adjustment value is added to WY, where the preset first adjustment value can be 5 kW, 10 kW, until W1 - WY < W3. When W1 is 150 kW and W is 100 kW, that is, W1 - W is 100 kW, which is less than W3, the over-demand is not triggered, and the anti-over-demand strategy is not executed. The power prediction method provided by some embodiments of the present disclosure can predict the power change within ten minutes after the anti-reverse current strategy or the anti-over-demand strategy is triggered and stopped. There is no need for the anti-reverse current strategy or the anti-over-demand strategy to run and stop for a period, and the subsequent power change of the energy storage device can be directly predicted based on the predicted first power. Compared with the related art, it can more efficiently and accurately predict the second power of the energy storage device within ten minutes after the anti-reverse current strategy or the anti-over-demand strategy is triggered and stopped.

Step 240: Predicting battery temperature of the energy storage device based on the ambient temperature, battery parameters, and the predicted first power.

In some embodiments of the present disclosure, the battery temperature of the energy storage device is predicted based on the ambient temperature, battery parameters, and the predicted first power. First, a temperature prediction model is trained using the second power, the ambient temperature, the battery parameters, and the power of the liquid cooler. The temperature prediction model in some embodiments of the present disclosure can be a Long-Short-Term Memory (LSTM) model or other temperature prediction models with similar prediction function. The present disclosure does not impose special restrictions on this temperature prediction model. Before training the temperature prediction model, data processing is also required for data such as the second power, the ambient temperature, the battery parameters, and the power of the liquid cooler. Data processing includes missing value processing, charging segment extraction processing, and normalization processing. Data missing may include continuous data missing and data missing at individual time points. Continuous data missing cannot be filled by referring to data from adjacent time points, so this data can be directly removed. Data missing at individual time points can be processed by the mean interpolation method. When abnormal data collection by the sensors of the battery system leads to abnormal voltage or temperature data, for example, the single-cell voltage of a lithium-ion battery far exceeds the temperature range of the lithium-ion battery, it is determined that there is an abnormal sensor data reading. When abnormal values appear continuously (number of times ≥ 3), the data will be processed according to the method for missing data, and this segment of abnormal data will be removed. When the number of continuous abnormal values is less than 3, the abnormal value will be replaced with the normal value from the previous time point to ensure that there is no abnormal jump in the battery temperature values within 30 seconds. In order to more accurately predict the temperature change during the charging period, charging segment extraction processing is performed. The present disclosure does not impose special restrictions on the method for charging segment extraction processing. Then, the ambient temperature, battery parameters, and the predicted first power are input into the temperature prediction model to predict the battery temperature of the energy storage device. The temperature prediction model in the present disclosure can predict the temperature change within ten minutes after the anti-reverse current strategy or the anti-over-demand strategy is triggered and stopped. There is no need for the anti-reverse current strategy or the anti-over-demand strategy to run and stop for a certain period, and the subsequent battery temperature change of the energy storage device can be directly predicted based on the predicted first power.

The temperature prediction method provided by some embodiments of the present disclosure can predict the temperature change within ten minutes after the anti-reverse current strategy or the anti-over-demand strategy is triggered and stopped. There is no need for the anti-reverse current strategy or the anti-over-demand strategy to run and stop for a certain period, and the subsequent battery temperature change of the energy storage device can be directly predicted based on the predicted first power. In the temperature prediction method provided by some embodiments of the present disclosure, combining the specific charging and discharging strategies of industrial and commercial energy storage devices, a power load prediction algorithm is used to dynamically process and adjust the power of the energy storage device, and the battery temperature of the energy storage device is predicted based on the predicted first power, thereby more efficiently and accurately predicting the battery temperature change.

The energy storage system controls the battery temperature through a liquid-cooling system to maintain the normal temperature of the battery and ensure the safety of the energy storage system. The liquid-cooling system adjusts the battery temperature through the circulation of the coolant. When the battery temperature is too high, the coolant absorbs heat and transfers it to the external environment, thereby reducing the battery temperature. Conversely, when the battery temperature is too low, the battery temperature can be increased by heating the coolant.

In the related art, the liquid-cooling system is passively started or shut down based on the battery temperature change. When the battery temperature does not reach the temperature threshold for starting the liquid-cooling system, the liquid-cooling system cannot be started. Alternatively, when the battery temperature does not reach the temperature threshold for shutting down the liquid-cooling system, the liquid-cooling system cannot be shut down. Therefore, the following problems may occur: in the initial stage of charging or discharging, the battery temperature has been rising, but the liquid-cooling system cannot be started to control the temperature; or after the battery stops charging or discharging, but the temperature has not reached the power-reduction threshold, the liquid cooler will continue to operate, increasing the energy consumption of the liquid-cooling system and resulting in a relatively low overall efficiency of the energy storage cabinet.

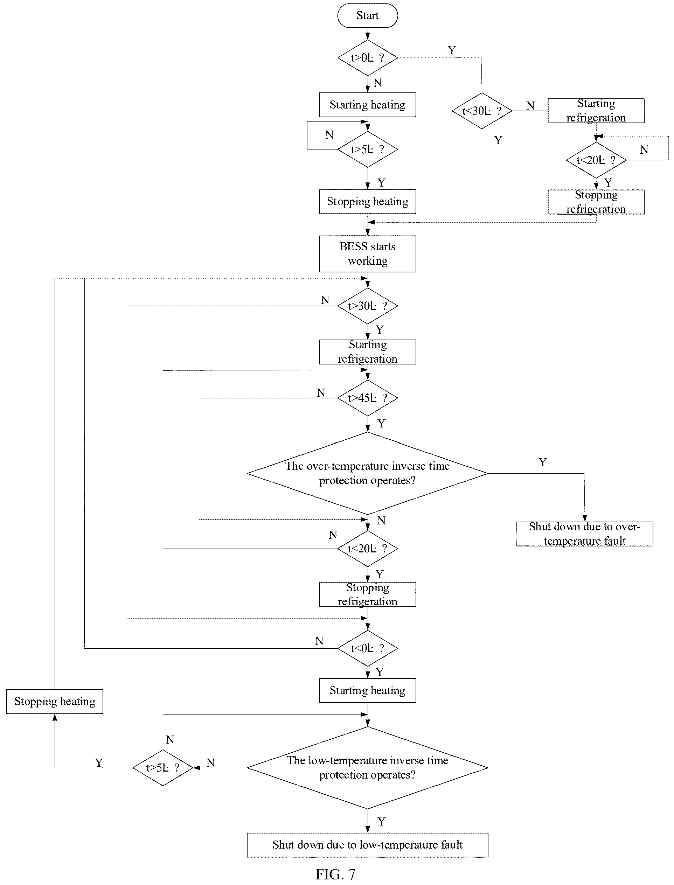

Fig. 7 is a schematic flowchart of a liquid-cooling control strategy in the related art. As shown in Fig. 7, when the battery temperature t ≤ 0°C, the liquid-cooling system starts heating. After starting heating, and when t > 5°C, the liquid-cooling system stops heating. When t ≥ 30°C, the liquid-cooling system starts refrigeration. After starting refrigeration, and when t < 20°C, the liquid-cooling system stops refrigeration. In the liquid-cooling control strategy of the related art shown in Fig. 7, the liquid-cooling system is passively started or shut down based on the change battery temperature change. For example, the liquid-cooling system executes the corresponding control strategy only when the battery temperature reaches the corresponding temperature threshold for starting or stopping heating, or when the battery temperature reaches the corresponding temperature threshold for starting or stopping refrigeration. Conversely, when the battery temperature does not reach the temperature threshold for starting the liquid-cooling system, the liquid-cooling system cannot be started. Alternatively, when the battery temperature does not reach the temperature threshold for shutting down the liquid-cooling system, the liquid-cooling system cannot be shut down. Therefore, the following problems may occur: in the initial stage of charging or discharging, the battery temperature has been rising, but the liquid-cooling system cannot be started to control the temperature, or after the battery stops charging or discharging, but the temperature has not reached the power-reduction threshold, the liquid cooler will continue to operate, increasing the energy consumption of the liquid-cooling system and resulting in a relatively low overall efficiency of the energy storage cabinet.

Based on this, some embodiments of the present disclosure further provides that the liquid-cooling mode of the energy storage device is predicted according to the predicted battery temperature, so that the energy storage system can execute the liquid-cooling strategy in advance and the liquid-cooling equipment can be started working earlier. This helps to actively control the liquid-cooling temperature of the energy storage cabinet, reduce the energy consumption of the liquid-cooling system, improve the overall efficiency of the energy storage cabinet, better control the battery temperature, more effectively protect the battery, and increase the service life of the battery and the benefits of the energy storage station. For example, when it is predicted that the liquid-cooling system will shut down after 2 minutes, the liquid-cooling system is shut down at the current moment, and allows the battery pack to cool naturally. Shutting down the liquid-cooling system in advance can reduce the energy consumption of the liquid-cooling system. Alternatively, when it is predicted that the liquid-cooling system will start refrigeration after 2 minutes, the liquid-cooling system is started at the current moment to reduce the temperature rise rate, preventing the temperature from rising sharply and reducing the temperature peak to protect the battery.

In some embodiments, the battery temperature of the energy storage device predicted in step 240 includes the maximum cell temperature T1 and the minimum cell temperature T2. After step S240, the temperature prediction method provided by some embodiments of the present disclosure further includes: obtaining a first liquid-cooling mode, which is the current liquid-cooling mode of the energy storage device; and determining a second liquid-cooling mode based on the first liquid-cooling mode, the maximum cell temperature, and/or the minimum cell temperature. The second liquid-cooling mode is the liquid-cooling mode of the energy storage device after a first duration.

The first duration refers to the prediction duration. In some embodiments of the present disclosure, the battery temperature of the energy storage device after the first duration is predicted according to the prediction model, and then the liquid-cooling mode of the energy storage device after the first duration is determined according to the predicted battery temperature. The first duration can be any value between 2 minutes and 10 minutes. Optionally, the first duration is 2 minutes, mainly considering that predicting the cell temperature 2 minutes in advance has a relatively high algorithmic accuracy for the prediction model. The accuracy decreases as the duration increases.

In some embodiments, the liquid-cooling modes of the energy storage cabinet include a shutdown mode, a first-level cooling mode, a second-level cooling mode, a third-level cooling mode, a self-circulation mode, and a heating mode. The target water temperatures of the heating mode, the first-level cooling mode, the second-level cooling mode, and the third-level cooling mode decrease in sequence. The target water temperature refers to the designed outlet temperature of the cooling water in the liquid-cooling system, that is, the designed temperature of the cooling water when it comes out of the condenser. As an example, the target water temperature of the heating mode is 27°C, the target water temperature of the first-level cooling mode is 22°C, the target water temperature of the second-level cooling mode is 18°C, and the target water temperature of the third-level cooling mode is 15°C. The shutdown mode means that the liquid-cooling system stops operating. The self-circulation mode means that the battery is at a relatively suitable temperature, and no temperature control for refrigeration or heating is performed. That is, the self-circulation of the heat-conducting medium is used to control the battery temperature, further reducing the energy consumption of the liquid-cooling unit.

It can be understood that each of the first liquid-cooling mode and the second liquid-cooling mode is one of the liquid-cooling modes of the energy storage cabinet.

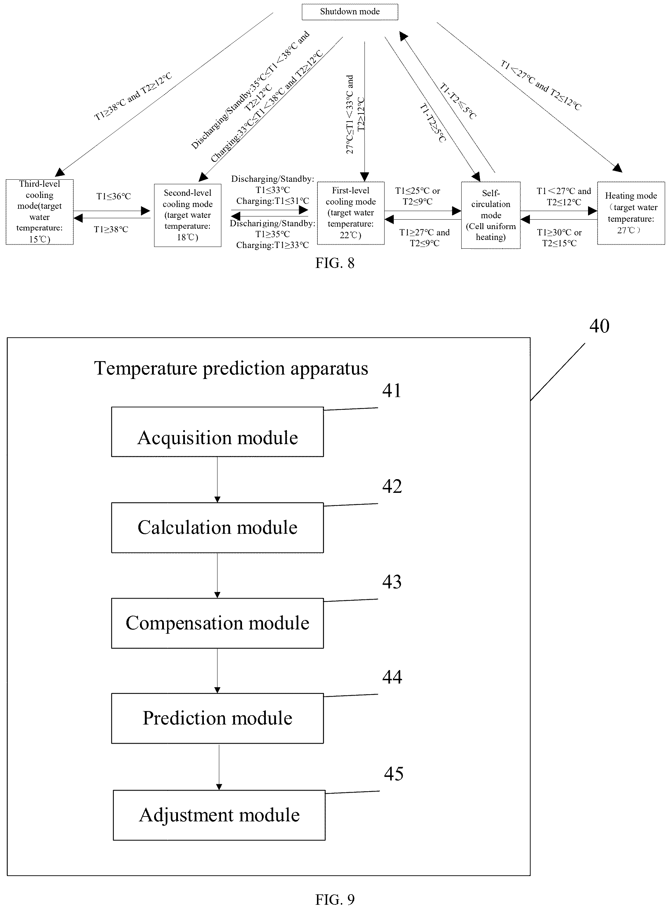

In some embodiments, as shown in Fig. 8, which is a structural schematic diagram showing liquid-cooling mode conversion provided by some embodiments of the present disclosure, the liquid-cooling mode conversion includes:
(1) In the case where the first liquid-cooling mode is the shutdown mode: when T1 ≥ 38°C and T2 ≥ 12°C, the second liquid-cooling mode is the third-level cooling mode; when the energy storage cabinet is in the discharging or standby state, with 35°C ≤ T1 < 38°C and T2 ≥ 12°C, or the energy storage cabinet is in the charging state, with 33°C ≤ T1 < 38°C and T2 ≥ 12°C, the second liquid-cooling mode is the second-level cooling mode; when 27°C ≤ T1 < 33°C and T2 ≥ 12°C, the second liquid-cooling mode is the first-level cooling mode; when T1 - T2 ≥ 5°C, the second liquid-cooling mode is the self-circulation mode; when T1 < 27°C and T2 ≤ 12°C, the second liquid-cooling mode is the heating mode.
(2) In the case where the first liquid-cooling mode is the third-level cooling mode: when T1 ≤ 36°C, the second liquid-cooling mode is the second-level cooling mode.
(3) In the case where the first liquid-cooling mode is the second-level cooling mode: when T1 ≥ 38°C, the second liquid-cooling mode is the third-level cooling mode; when the energy storage cabinet is in the discharging or standby state, with T1 ≤ 33°C, or the energy storage cabinet is in the charging state, with T1 ≤ 31°C, the second liquid-cooling mode is the first-level cooling mode.
(4) In the case where the first liquid-cooling mode is the first-level cooling mode: when the energy storage cabinet is in the discharging or standby state, with T1 ≥ 35°C, or the energy storage cabinet is in the charging state, with T1 ≥ 33°C, the second liquid-cooling mode is the second-level cooling mode; when T1 ≤ 25°C or T2 ≤ 9°C, the second liquid-cooling mode is the self-circulation mode.
(5) In the case where the first liquid-cooling mode is the self-circulation mode: when T1 ≥ 27°C and T2 ≤ 9°C, the second liquid-cooling mode is the first-level cooling mode; when T1 < 27°C and T2 ≤ 12°C, the second liquid-cooling mode is the heating mode; when T1 - T2 ≤ 5°C, the second liquid-cooling mode is the shutdown mode.
(6) In the case where the first liquid-cooling mode is the heating mode: when T1 ≥ 30°C or T2 ≤ 15°C, the second liquid-cooling mode is the self-circulation mode.

The temperature prediction method provided by some embodiments of the present disclosure can predict the temperature change within ten minutes after the anti-reverse current strategy or the anti-over-demand strategy is triggered and stopped. There is no need for the anti-reverse current strategy or the anti-over-demand strategy to run and stop for a certain period, and the subsequent battery temperature change of the energy storage device can be directly predicted based on the predicted first power. In the temperature prediction method provided by some embodiments of the present disclosure, combining the specific charging and discharging strategies of industrial and commercial energy storage devices, a power load prediction algorithm is used to dynamically process and adjust the power of the energy storage device, and the battery temperature of the energy storage device is predicted based on the predicted first power, thereby more efficiently and accurately predicting the battery temperature change. Further, by predicting the liquid-cooling mode of the energy storage device according to the predicted battery temperature, the energy storage system can execute the liquid-cooling strategy in advance and the liquid-cooling equipment can be started working earlier. This helps to actively control the liquid-cooling temperature of the energy storage cabinet, reduce the energy consumption of the liquid-cooling system, improve the overall efficiency of the energy storage cabinet, better control the battery temperature, more effectively protect the battery, and increase the service life of the battery and the benefits of the energy storage station. The temperature prediction apparatus for the energy storage device provided by some embodiments of the present disclosure can execute the temperature prediction method for the energy storage device provided by any embodiment of the present disclosure, and has the corresponding functional modules and beneficial effects for executing the method, for the similar parts, reference can be made to the above description of the temperature prediction method for the energy storage device provided by some embodiments of the present disclosure, and details are not repeated here.

Fig. 9 is a schematic structural diagram of an apparatus provided by some embodiments of the present disclosure. As shown in Fig. 9, the temperature prediction apparatus 40 may include an acquisition module 41, a calculation module 42, a compensation module 43, and a prediction module 44.

The acquisition module 41 is configured to acquire the ambient temperature and the battery parameters of the energy storage device. It is also configured to obtain the current first power, the third power, and the fourth power of the energy storage device. The current first power is used to indicate the current operating power of the energy storage device. The third power is used to indicate the anti-reverse current threshold power of the energy storage device, and the fourth power is used to indicate the anti-over-demand threshold power of the energy storage device.

The calculation module 42 is configured to calculate the second power of the energy storage device, which is used to indicate the load power of the energy storage device. When the difference between the second power and the current first power is not less than the fourth power, it determines the state of the energy storage device.

The compensation module 43 is configured to compensate the predicted first power based on the current first power when the energy storage device is in the charging state. The predicted first power is used to indicate the predicted operating power of the energy storage device. The compensation module 43 is further configured to determine whether the difference between the second power and the compensated predicted first power is less than the fourth power, when the difference between the second power and the compensated predicted first power is less than the fourth power, the predicted first power is output. Otherwise, the preset first adjustment value is added to the predicted first power until the difference between the second power and the current first power is less than the fourth power, and then the adjusted predicted first power is output.

The compensation module 43 is further configured to compensate the predicted first power based on the current first power when the energy storage device is in the discharging state. The compensation module 43 is further configured to determine whether the difference between the second power and the predicted first power is less than the fourth power, the predicted first power is output. When the difference between the second power and the predicted first power is not less than the fourth power, the preset first adjustment value is added to the predicted first power until the difference between the second power and the current first power is less than the fourth power, and the adjusted predicted first power is output.

The compensation module 43 is further configured to set the predicted first power to zero when the energy storage device is in the static fully-charged state. The compensation module 43 is further configured to determine whether the difference between the second power and the predicted first power is less than the fourth power. When the difference between the second power and the predicted first power is less than the fourth power, the predicted first power is output. When the difference between the second power and the predicted first power is not less than the fourth power, the preset first adjustment value is added to the predicted first power until the difference between the second power and the current first power is less than the fourth power, and the adjusted predicted first power is output.

The prediction module 44 is configured to predict the battery temperature of the energy storage device based on the ambient temperature, the battery parameters, and the predicted first power.

In one or more embodiments, the battery parameters include a parameter of State of Charge (SOC) and a parameter of State of Health (SOH).

In one or more embodiments, the calculation module 42 is configured to calculate the second power of the energy storage device based on historical power data, date data, weather conditions, and air quality of the energy storage device.

In one or more embodiments, the calculation module 42 is configured to input the historical power data, date data, weather conditions, and air quality of the energy storage device into a preset model, so as to output the power load demand of the energy storage device, and calculate the second power.

In one or more embodiments, the temperature prediction apparatus may further include an adjustment module 45. The adjustment module 45 is configured to adjust the predicted first power based on the current first power and a preset second adjustment value when the difference between the second power and the current first power is not greater than the third power.

In one or more embodiments, the adjustment module 45 is further configured to: increase the predicted first power until the charging state stops when the energy storage device is in the charging state; increase the predicted first power for discharging when the energy storage device is in the discharging state; increase the predicted first power for discharging when the energy storage device is in the static fully-charged state.

In one or more embodiments, the compensation module 43 is configured to compensate the predicted first power based on the current first power when the difference between the second power and the current first power is not greater than the third power. The compensation module 43 is further configured to determine whether the difference between the second power and the predicted first power is greater than the third power. When the difference between the second power and the predicted first power is greater than the third power, the predicted first power is output. When the difference between the second power and the predicted first power is not greater than the third power, the preset second adjustment value is subtracted from the predicted first power until the difference between the second power and the current first power is greater than the third power, and the adjusted predicted first power is output.

In one or more embodiments, the prediction module 44 is further configured to: train a temperature prediction model using the second power, the ambient temperature, the battery parameters, and the power of the liquid cooler; and input the ambient temperature, the battery parameters, and the predicted first power into the temperature prediction model to predict the battery temperature of the energy storage device.

In one or more embodiments, the battery temperature of the energy storage device includes the maximum cell temperature T1 and the minimum cell temperature T2. The acquisition module is further configured to obtain the first liquid-cooling mode, which is the current liquid-cooling mode of the energy storage device.

The apparatus further includes a determination module configured to determine the second liquid-cooling mode, which is used to indicate the liquid-cooling mode of the energy storage device after a first duration, based on the first liquid-cooling mode, the maximum cell temperature T1, and/or the minimum cell temperature T2.

In one or more embodiments, the liquid-cooling modes of the energy storage device include the shutdown mode, the first-level cooling mode, the second-level cooling mode, the third-level cooling mode, the self-circulation mode, and the heating mode. The target water temperatures of the heating mode, the first-level cooling mode, the second-level cooling mode, and the third-level cooling mode decrease in sequence.

In one or more embodiments, in the case where the first liquid-cooling mode is the first-level cooling mode: when T1 ≥ 38°C and T2 ≥ 12°C, the second liquid-cooling mode is the third-level cooling mode; when the energy storage device is in the discharging or standby state, with 35°C ≤ T1 < 38°C and T2 ≥ 12°C, or the energy storage device is in the charging state, with 33°C ≤ T1 < 38°C and T2 ≥ 12°C, the second liquid-cooling mode is the second-level cooling mode; when 27°C ≤ T1 < 33°C and T2 ≥ 12°C, the second liquid-cooling mode is the first-level cooling mode; when T1 - T2 ≥ 5°C, the second liquid-cooling mode is the self-circulation mode; when T1 < 27°C and T2 ≤ 12°C, the second liquid-cooling mode is the heating mode; when T1 ≤ 36°C, the second liquid-cooling mode is the second-level cooling mode.

In one or more embodiments, in the case where the first liquid-cooling mode is the second-level cooling mode: When T1 ≥ 38°C, the second liquid-cooling mode is the third-level cooling mode; when the energy storage device is in the discharging or standby state, with T1 ≤ 33°C, or the energy storage device is in the charging state, with T1 ≤ 31°C, the second liquid-cooling mode is the first-level cooling mode.

In one or more embodiments, in the case where the first liquid-cooling mode is the first-level cooling mode: when the energy storage device is in the discharging or standby state, with T1≥35°C, or the energy storage device is in the charging state, with T1≥33°C, the second liquid-cooling mode is the second-level cooling mode; when T1≤25°C or T2≤9°C, the second liquid-cooling mode is the self-circulation mode.

In one or more embodiments, in the case where the first liquid-cooling mode is the self-circulation mode: when T1 ≥ 27°C and T2 ≤ 9°C, the second liquid-cooling mode is the first-level cooling mode; when T1 < 27°C and T2 ≤ 12°C, the second liquid-cooling mode is the heating mode; when T1 - T2 ≤ 5°C, the second liquid-cooling mode is the shutdown mode.

In one or more embodiments, in the case where the first liquid-cooling mode is the heating mode: when T1 ≥ 30°C or T2 ≤ 15°C, the second liquid-cooling mode is the self-circulation mode.

In one or more embodiments, when the second power is greater than the third power and less than the fourth power, the predicted first power is equal to the second power.

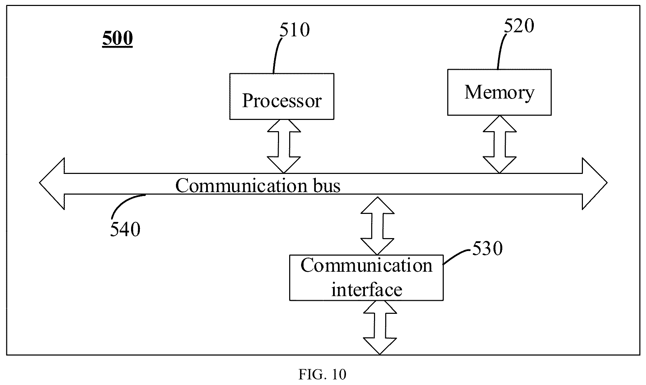

An exemplary electronic device provided by some embodiments of the present disclosure will be further introduced with reference to Fig. 10. Fig. 10 shows a schematic structural diagram of an electronic device 500.

The above-mentioned electronic device 500 may include at least one processor; and at least one memory communicatively connected to the above-mentioned processor. The above-mentioned memory stores program instructions executable by the above-mentioned processor, and the processor can call the above-mentioned program instructions to execute the temperature prediction method for the energy storage device provided by the embodiments shown in the present disclosure.

Fig. 10 shows a block diagram of an exemplary electronic device 500 suitable for implementing some embodiments of the present disclosure. The electronic device 500 shown in Figure 10 is merely an example and should not impose any limitations on the functions and scope of use of some embodiments of the present disclosure.

As shown in Fig. 10, the electronic device 500 is presented in the form of a general-purpose computing device. The components of the electronic device 500 may include, but are not limited to: one or more processors 510, a memory 520, a communication bus 540 connecting different system components (including the memory 520 and the processor 510), and a communication interface 530.

The communication bus 540 represents one or more of several types of bus structures, including a memory bus or a memory controller, a peripheral bus, a graphics acceleration port, a processor, or a local bus using any of a variety of bus structures. For example, these architectures include, but are not limited to, the Industry Standard Architecture (ISA) bus, the Micro Channel Architecture (MAC) bus, the Enhanced ISA bus, the Video Electronics Standards Association (VESA) local bus, and the Peripheral Component Interconnection (PCI) bus.

The electronic device 500 typically includes a variety of computer-system-readable media. These media can be any available media that can be accessed by the electronic device, including volatile and non-volatile media, removable and non-removable media.

The memory 520 may include computer-system-readable media in the form of volatile memory, such as Random Access Memory (RAM) and/or cache memory. The electronic device may further include other removable/non-removable, and volatile/non-volatile computer-system storage media. Although not shown in Fig. 3, a disk drive for reading from and writing to a removable non-volatile magnetic disk (such as a floppy disk) and an optical disk drive for reading from and writing to a removable non-volatile optical disk (such as a Compact Disc Read Only Memory (CD-ROM), a Digital Video Disc Read Only Memory (DVD-ROM), or other optical media) may be provided. In these cases, each drive may be connected to the communication bus 540 through one or more data-media interfaces. The memory 520 may include at least one program product having a set (e.g., at least one) of program modules configured to perform the functions of the various embodiments of the present disclosure.

A program/utility having a set (at least one) of program modules may be stored in the memory 520. Such program modules include, but are not limited to, an operating system, one or more application programs, other program modules, and program data. Each of these examples or a combination thereof may include an implementation of a network environment. Program modules typically perform the functions and/or methods described in some embodiments of the present disclosure.

The electronic device 500 may also communicate with one or more external devices (such as a keyboard, a pointing device, a display, etc.), may also communicate with one or more devices that enable a user to interact with the electronic device, and/or communicate with any device (such as a network card, a modem, etc.) that enables the electronic device to communicate with one or more other computing devices. This communication can be carried out through the communication interface 530. Moreover, the electronic device 500 may also communicate with one or more networks (such as a Local Area Network (LAN), a Wide Area Network (WAN), and/or a public network, such as the Internet) through a network adapter (not shown in Fig. 10). The above-mentioned network adapter can communicate with other modules of the electronic device through the communication bus 540. It should be understood that although not shown in Fig. 10, other hardware and/or software modules may be used in conjunction with the electronic device 500, including but not limited to microcode, device drivers, redundant processing units, external disk drive arrays, Redundant Arrays of Independent Drives (RAID) systems, tape drives, and data backup storage systems.

The processor 510 executes various functional applications and data processing, for example, implements the method provided in some embodiments of the present disclosure, by running programs stored in the memory 520.

It can be understood that the interface connection relationships between the various modules shown in some embodiments of the present disclosure are merely illustrative and do not constitute a structural limitation of the electronic device 500. In some other embodiments of the present disclosure, the electronic device 500 may also adopt different interface connection methods from the above-mentioned embodiments or a combination of multiple interface connection methods.

In the above embodiments, the processor may, for example, include a Central Processing Unit (CPU), a Digital Signal Processor (DSP), a microcontroller, or a digital signal processor. It may also include a Graphics Processing Unit (GPU), an embedded Neural-network Process Unit (NPU), and an Image Signal Processing (ISP). The processor may also include necessary hardware accelerators or logical processing hardware circuits, such as an ASIC, or one or more integrated circuits for controlling the execution of the technical solution programs of the present disclosure. In addition, the processor may have the function of operating one or more software programs, and the software programs may be stored in the storage medium.

The embodiments of the present disclosure also provide a computer-readable storage medium. A computer program is stored in the computer-readable storage medium, and when it runs on a computer, it enables the computer to execute the temperature prediction method provided in the embodiments shown in the present disclosure.

The embodiments of the present disclosure also provide a computer program product. The computer program product includes a computer program, and when it runs on a computer, it enables the computer to execute the temperature prediction method provided in the embodiments shown in the present disclosure.

Those of ordinary skill in the art may realize that the units and algorithm steps described in the embodiments herein can be implemented in a combination of electronic hardware, computer software, and electronic hardware. Whether these functions are executed in hardware or software depends on the specific application and design constraint conditions of the technical solution. Professional technicians can use different methods for each specific application to implement the described functions, but such implementations should not be considered to be beyond the scope of the present disclosure.

Those skilled in the art can clearly understand that for the convenience and brevity of the description, the specific working processes of the systems, devices, and units described above can refer to the corresponding processes in the foregoing method embodiments, and details are not repeated here.

In some embodiments provided in the present disclosure, if any function is implemented in the form of a software functional unit, and sold or used as an independent product, it can be stored in a computer-readable storage medium. Based on such an understanding, the essence of the technical solution of the present disclosure, or the part that contributes to the existing technology, or part of the technical solution can be embodied in the form of a software product. The computer software product is stored in a storage medium and includes several instructions to enable a computer device (which can be a personal computer, a server, or a network device, etc.) to execute all or part of the steps of the methods described in the various embodiments of the present disclosure. The foregoing storage media include: U - disks, mobile hard drives, Read-Only Memory (ROM), Random Access Memory (RAM), magnetic disks, or optical disks and other media that can store program codes.

The above are only the preferred embodiments of the present disclosure and are not intended to limit the present disclosure.

Finally, it should be noted that the above embodiments are only used to illustrate the technical solutions of the present disclosure, not to limit them. Although the present disclosure has been described in detail with reference to the foregoing embodiments, those of ordinary skill in the art should understand that they can still modify the technical solutions described in the foregoing embodiments, or make equivalent substitutions for some or all of the technical features. The scope of the present disclosure shall be defined by the appended claims.

## Claims

1. A temperature prediction method, applied to an energy storage device, wherein the method comprises:
obtaining an ambient temperature and battery parameters of the energy storage device;
obtaining a current first power, a third power, and a fourth power of the energy storage device, wherein the current first power is configured to indicate a current operating power of the energy storage device, the third power is configured to indicate an anti-reverse current threshold power of the energy storage device, and the fourth power is configured to indicate an anti-over-demand threshold power of the energy storage device;
calculating a second power of the energy storage device, wherein the second power is configured to indicate a load power of the energy storage device, and determining a state of the energy storage device, in response to a difference between the second power and the current first power being not less than the fourth power;
when the energy storage device is in a charging state, compensating a predicted first power based on the current first power, wherein the predicted first power is configured to indicate a predicted operating power of the energy storage device; determining whether a difference between the second power and the compensated predicted first power is less than the fourth power; in response to the difference between the second power and the compensated predicted first power being less than the fourth power, outputting the predicted first power; and in response to the difference between the second power and the predicted first power being not less than the fourth power, adding a preset first adjustment value to the predicted first power until the difference between the second power and the current first power is less than the fourth power, and outputting the adjusted predicted first power;
when the energy storage device is in a discharging state, compensating the predicted first power based on the current first power; determining whether the difference between the second power and the predicted first power is less than the fourth power; in response to the difference between the second power and the predicted first power being less than the fourth power, outputting the predicted first power; in response to the difference between the second power and the predicted first power being not less than the fourth power, adding the preset first adjustment value to the predicted first power until the difference between the second power and the current first power is less than the fourth power, and outputting the adjusted predicted first power;
when the energy storage device is in a static fully-charged state, setting the predicted first power to zero; determining whether the difference between the second power and the predicted first power is less than the fourth power; in response to the difference between the second power and the predicted first power being less than the fourth power, outputting the predicted first power; in response to the difference between the second power and the predicted first power being not less than the fourth power, adding the preset first adjustment value to the predicted first power until the difference between the second power and the current first power is less than the fourth power, and outputting the adjusted predicted first power; and
predicting a battery temperature of the energy storage device based on the ambient temperature, the battery parameters, and the predicted first power.

2. The temperature prediction method according to claim 1, wherein the battery parameters include a parameter of state of charge (SOC) and a parameter of state of health (SOH).

3. The temperature prediction method according to claim 1 or 2, wherein the calculating a second power of the energy storage device comprises:
calculating the second power of the energy storage device based on historical power data, date data, weather condition, and air quality of the energy storage device.

4. The temperature prediction method according to any one of the preceding claims, wherein the calculating the second power of the energy storage device based on historical power data, date data, weather condition, and air quality of the energy storage device comprises:
inputting the historical power data, date data, weather condition, and air quality of the energy storage device into a preset model, to output power load demand of the energy storage device and calculate the second power of the energy storage device.

5. The temperature prediction method according to any one of the preceding claims, further comprising:
in response to the difference between the second power and the current first power being not greater than the third power, adjusting the predicted first power based on the current first power and a preset second adjustment value.

6. The temperature prediction method according to any one of the preceding claims, wherein the determining a state of the energy storage device and adjusting the first power comprises:
when the energy storage device is in the charging state, increasing the predicted first power until the charging state stops;
when the energy storage device is in the discharging state, increasing the predicted first power for discharging; and
when the energy storage device is in the static fully-charged state, increasing the predicted first power for discharging.

7. The temperature prediction method according to claim 5 or 6, wherein the adjusting the predicted first power based on the current first power and a preset second adjustment value comprises:
in response to the difference between the second power and the current first power being not greater than the third power, compensating the predicted first power based on the current first power;
determining whether the difference between the second power and the predicted first power is greater than the third power;
in response to the difference between the second power and the predicted first power being greater than the third power, outputting the predicted first power; and
in response to the difference between the second power and the predicted first power being not greater than the third power, subtracting the preset second adjustment value from the predicted first power until the difference between the second power and the current first power is greater than the third power, and outputting the adjusted predicted first power.

8. The temperature prediction method according to any one of the preceding claims, wherein the energy storage device further comprises a liquid cooler, and the predicting battery temperature of the energy storage device based on the ambient temperature, the battery parameters, and the predicted first power comprises:
training a temperature prediction model based on the second power, the ambient temperature, the battery parameters, and power of the liquid cooler; and
inputting the ambient temperature, the battery parameters, and the predicted first power into the temperature prediction model to predict the battery temperature of the energy storage device.

9. The temperature prediction method according to any one of the preceding claims, wherein the battery temperature of the energy storage device comprises a maximum cell temperature T1 and a minimum cell temperature T2, and the method further comprises:
obtaining a first liquid-cooling mode, wherein the first liquid-cooling mode is a current liquid-cooling mode of the energy storage device; and
determining a second liquid-cooling mode based on the first liquid-cooling mode, the maximum cell temperature T1, and/or the minimum cell temperature T2, wherein the second liquid-cooling mode is a liquid-cooling mode of the energy storage device after a first duration.

10. The temperature prediction method according to claim 9, wherein liquid-cooling modes of the energy storage device comprise a shutdown mode, a first-level cooling mode, a second-level cooling mode, a third-level cooling mode, a self-circulation mode, and a heating mode, and target water temperatures of the heating mode, the first-level cooling mode, the second-level cooling mode, and the third-level cooling mode decrease in sequence.

11. The temperature prediction method according to claim 9 or 10, wherein the determining a second liquid-cooling mode based on the first liquid-cooling mode, the maximum cell temperature T1, and/or the minimum cell temperature T2 comprises:
in a case where the first liquid-cooling mode is the shutdown mode, determining the second liquid-cooling mode, comprising:
when T1 ≥ 38°C and T2 ≥ 12°C, determining that the second liquid-cooling mode is the third-level cooling mode;
when the energy storage device is in the discharging state or a standby state, with 35°C ≤ T1 < 38°C and T2 ≥ 12°C, or when the energy storage device is in the charging state, with 33°C ≤ T1 < 38°C and T2 ≥ 12°C, determining that the second liquid-cooling mode is the second-level cooling mode;
when 27°C ≤ T1 < 33°C and T2 ≥ 12°C, determining that the second liquid-cooling mode is the first-level cooling mode;
when T1 - T2 ≥ 5°C, determining that the second liquid-cooling mode is the self-circulation mode; or
when T1 < 27°C and T2 ≤ 12°C, determining that the second liquid-cooling mode is the heating mode,
or
in a case where the first liquid-cooling mode is the third-level cooling mode, with T1 ≤ 36°C, determining that the second liquid-cooling mode is the second-level cooling mode,
or
in a case where the first liquid-cooling mode is the second-level cooling mode, with T1 ≥ 38°C, determining that the second liquid-cooling mode is the third-level cooling mode; or
when the energy storage device is in the discharging state or a standby state, with T1 ≤ 33°C, or when the energy storage device is in the charging state, with T1 ≤ 31°C, determining that the second liquid-cooling mode is the first-level cooling mode,
or
in a case where the first liquid-cooling mode is the first-level cooling mode, determining the second liquid-cooling mode, comprising:
when the energy storage device is in the discharging state or a standby state, with T1 ≥ 35°C, or when the energy storage device is in the charging state, with T1 ≥ 33°C, determining that the second liquid-cooling mode is the second-level cooling mode; or
when T1 ≤ 25°C or T2 ≤ 9°C, determining that the second liquid-cooling mode is the self-circulation mode,
or
in a case where the first liquid-cooling mode is the self-circulation mode, determining the second liquid-cooling mode, comprising:
when T1 ≥ 27°C and T2 ≤ 9°C, determining that the second liquid-cooling mode is the first-level cooling mode;
when T1 < 27°C and T2 ≤ 12°C, determining that the second liquid-cooling mode is the heating mode; or
when T1 - T2 ≤ 5°C, determining that the second liquid-cooling mode is the shutdown mode,
or
in a case where the first liquid-cooling mode is the heating mode, when T1 ≥ 30°C or T2 ≤ 15°C, determining that the second liquid-cooling mode is the self-circulation mode.

12. The temperature prediction method according to any one of the preceding claims, further comprising:
in response to the second power being greater than the third power and the second power being less than the fourth power, determining that the predicted first power is the second power.

13. A temperature prediction apparatus, applied to an energy storage device, wherein the temperature prediction apparatus comprises:
an acquisition module configured to obtain an ambient temperature and battery parameters of the energy storage device, and further configured to obtain a current first power, a third power and a fourth power of the energy storage device, wherein the current first power is configured to indicate a current operating power of the energy storage device, the third power is configured to indicate an anti-reverse current threshold power of the energy storage device, and the fourth power is configured to indicate an anti-over-demand threshold power of the energy storage device;
a calculation module configured to calculate a second power of the energy storage device, and further configured to determine a state of the energy storage device, in response to a difference between the second power and the current first power being not less than the fourth power, wherein the second power is configured to indicate a load power of the energy storage device;
a compensation module configured to:
when the energy storage device is in a charging state, compensate a predicted first power based on the current first power, wherein the predicted first power is configured to indicate a predicted operating power of the energy storage device;
determine whether a difference between the second power and the compensated predicted first power is less than the fourth power;
in response to the difference between the second power and the compensated predicted first power being less than the fourth power, output the predicted first power; and
in response to the difference between the second power and the predicted first power being not less than the fourth power, add a preset first adjustment value to the predicted first power until the difference between the second power and the current first power is less than the fourth power, and output the adjusted predicted first power;
wherein the compensation module is further configured to:
when the energy storage device is in a discharging state, compensate the predicted first power based on the current first power;
determine whether the difference between the second power and the predicted first power is less than the fourth power;
in response to the difference between the second power and the predicted first power being less than the fourth power, output the predicted first power; and
in response to the difference between the second power and the predicted first power being not less than the fourth power, add the preset first adjustment to the predicted first power until the difference between the second power and the current first power is less than the fourth power, and output the adjusted predicted first power;
wherein the compensation module is further configured to:
when the energy storage device is in a static fully-charged state, set the predicted first power to zero;
determine whether the difference between the second power and the predicted first power is less than the fourth power;
in response to the difference between the second power and the predicted first power being less than the fourth power, output the predicted first power; and
in response to the difference between the second power and the predicted first power being not less than the fourth power, add the preset first adjustment value to the predicted first power until the difference between the second power and the current first power is less than the fourth power, and output the adjusted predicted first power;
wherein the temperature prediction apparatus further comprises:
a prediction module configured to predict a battery temperature of the energy storage device based on the ambient temperature, the battery parameters and the predicted first power.

14. An electronic device, comprising at least one processor and a memory, wherein the memory is configured to store a computer program, and the at least one processor is configured to run the computer program, and execute the temperature prediction method according to any one of claims 1 to 12 when the computer program is run on a computer.

15. An energy storage system, comprising a battery pack, a power conversion system (PCS) and an energy management system (EMS), wherein the EMS is configured to implement the temperature prediction method according to any one of claims 1 to 12.
